# EUROPEAN PATENT APPLICATION

(11) **EP 1 363 334 A1**
(43) Date of publication of application: **19.11.2003**
(21) Application number: 02100440.3
(22) Date of filing: 03.05.2002
(51) Int. Cl.: H01L 33/00

(54) **Gallium nitride-based compound semiconductor device with a ZnO electrode**

(71) Applicant: Nitride Semiconductors Co., Ltd., Naruto-shi, Tokushima 771-0360 (JP); Sakai, Shiro, Tokushima 770-8072 (JP)
(72) Inventor: Sakai, Shiro, 770-8072, Tokushima (JP)
(74) Representative: Weihs, Bruno

(57) **Abstract**

A gallium nitride-based light emitting element with improved light emission efficiency. A gallium nitride-based light emitting element is constructed by forming an n type GaN buffer layer (12), an n type GaN layer (14), an InGaN emissive layer (16), and a p type GaN layer (18) in that order on a substrate (10), and forming a negative electrode (20) and a positive electrode (22). A transparent ZnO electrode (21) is formed on the p type GaN layer and abutting the positive electrode. Uniform current is supplied to the emissive layer by the ZnO electrode, and, at the same time, light from the emissive layer is transmitted through the ZnO electrode and externally emitted.

## Description

### BACKGROUND OF THE INVENTION

### 1. Field of the Invention

The present invention relates to a gallium nitride-based semiconductor device and, in particular, to a gallium nitride-based semiconductor device with improved light emission efficiency.

### 2. Description of the Related Art

In recent years, light emitting elements which use gallium nitride(GaN)-based compound semiconductor have been developed for application in blue LEDs or the like.

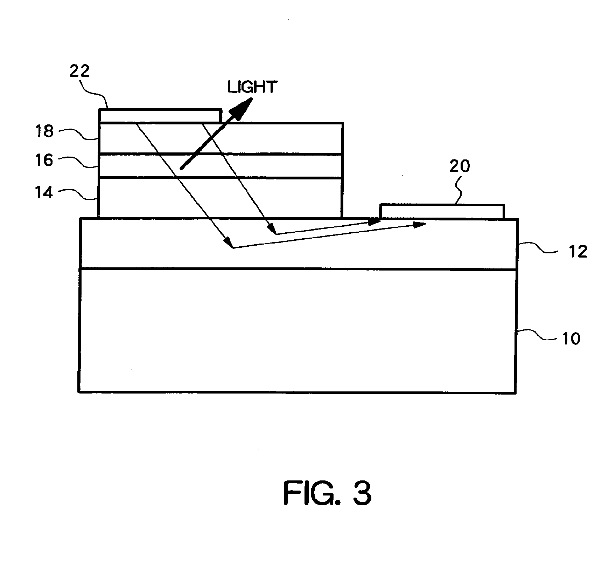

Fig. 3 shows a structure of a conventional light emitting element which uses a GaN-based compound semiconductor. An n type GaN buffer layer 12 is formed on a sapphire substrate 10 and a thin n type GaN layer 14 is formed on the GaN buffer layer 12. Then, an emissive layer such as, for example, an InGaN emissive layer 16, is formed. A p type GaN layer 18 is then formed, to thereby construct a PN junction. After the p type GaN layer 18 is formed, a portion of the surface is etched away to expose the surface of the n type GaN buffer layer 12. A negative electrode 20 is formed on the n type GaN buffer layer 12 and a positive electrode 22 is formed on the surface of the p type GaN layer 18. By applying a forward voltage to the positive electrode 22 and the negative electrode 20, carriers are injected into the InGaN emissive layer 16, and light of a predetermined wavelength (blue color) is emitted out from the InGaN emissive layer 16.

In the structure shown in Fig. 3, because current flows from the positive electrode 22 towards the negative electrode 20, and, in particular, because the maximum current flows below the positive electrode 22, light emission is most intense below the positive electrode 22. However, emission of this light out from the InGaN emissive layer 16 is blocked by the positive electrode 22, and, therefore, there is a problem in that the emitted light cannot be efficiently emitted to outside the device.

To this end, formation of a transparent electrode on the p type GaN layer 18 in addition to the metal positive electrode 22 has been proposed. By forming a transparent electrode, it is possible to uniformly flow the current almost entirely of the InGaN emissive layer 16 instead of flowing current only to the portion below the positive electrode 22, and, at the same time, the light emission efficiency can be improved by extracting light through the transparent electrode.

Ni/Au electrodes, ITO (Indium Tin Oxide) electrodes, and other such electrodes are currently being used as transparent electrodes. Although a thicker electrode has an advantage in that the current can be more widely dispersed, a metal electrode such as a Ni/Au electrode also has a disadvantage that the light transmittance is reduced. If the electrode is too thin, on the other hand, although the light transmittance can be improved, the current dispersal tends to be narrower because the resistance in the lateral direction of the film is increased. ITO has a high light transmittance at a wavelength of 400 nm or greater. However, because ITO has an n type conductivity characteristic and the resistivity is greater than that of a metal, ohmic contact between the ITO and p type GaN layer is inferior, and, thus, there is a problem in that current tends not to flow uniformly. Moreover, etching of the ITO is relatively difficult and the shapes of the ends of the etched pattern tend to deteriorate. Therefore, there is a further problem in that an electrode of a desired shape cannot be obtained when ITO is machined.

### SUMMARY OF THE INVENTION

The present invention was conceived to solve at least the above problems and one object of the present invention is to improve the light emission efficiency in a GaN-based compound semiconductor device having a GaN-based emissive layer.

In order to achieve at least the object mentioned above, according to the present invention, there is provided a gallium nitride-based compound semiconductor device comprising a substrate; a first conductive type GaN-based layer formed on the substrate; a GaN-based emissive layer formed on the first conductive type GaN-based layer; a second conductive type GaN-based layer formed on the GaN-based emissive layer; a first electrode formed on the first conductive type GaN-based layer; and a second electrode formed on the second conductive type GaN-based layer. A portion of the second electrode is formed by ZnO transparent electrode. The first conductive type may be, for example, n type, with corresponding second conductive type being the p type. Because ZnO is transparent for light of a predetermined wavelength (350 nm) or longer, the light from the GaN-based emissive layer can be emitted to the outside without being blocked. Moreover, because the resistivity of ZnO is relatively small compared to a metal film and ZnO has superior ohmic contact with a GaN-based layer, uniform flow of current within the emissive layer is facilitated.

According to one aspect of the present invention, an n type GaN-based layer, a GaN-based emissive layer, and a p type GaN-based layer are formed on a substrate in that order. A positive electrode is formed on the p type GaN-based layer and, after a portion of the n type GaN-based layer is exposed, a negative electrode is formed on the n type GaN-based layer. A ZnO transparent electrode is formed on the p type GaN-based layer, abutting the positive electrode. Because a p type ZnO transparent electrode is used to correspond to the positive electrode, electric conductivity is improved.

The present invention becomes more readily apparent from the following description of a preferred embodiment.

### BRIEF DESCRIPTION OF THE DRAWINGS

Fig 1. is a diagram showing a structure of a semiconductor device according to the present invention.
Fig. 2 is a flowchart showing the manufacturing process for a semiconductor device shown in Fig. 1.
Fig. 3 is a diagram showing a structure of a conventional semiconductor device.

### DESCRIPTION OF THE PREFERRED EMBODIMENT

A preferred embodiment of the present invention will now be described referring to the drawings.

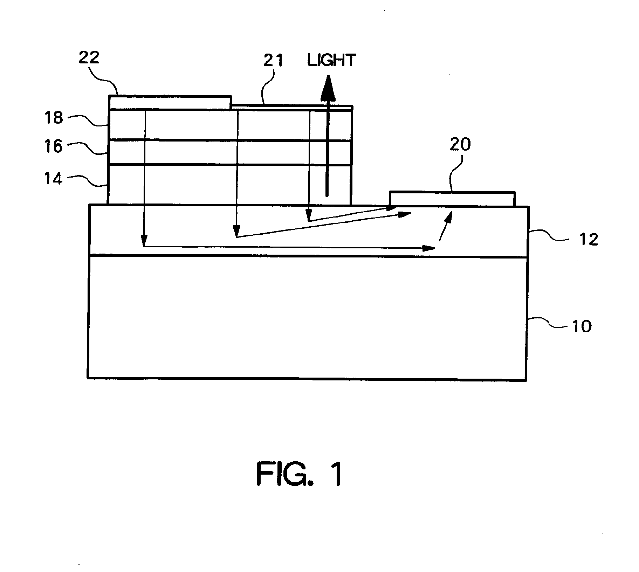

Fig. 1 shows a structure of a GaN-based semiconductor device according to the present embodiment. The structure shown in Fig. 1 is similar to the structure shown in Fig. 3, except that, in addition to the positive electrode 22 being formed on the p type GaN layer 18, a transparent electrode 21 is formed on the p type GaN layer 18 and abutting the positive electrode. The transparent electrode 21 is made of ZnO and is integrated with the positive electrode 22 to constitute an electrode.

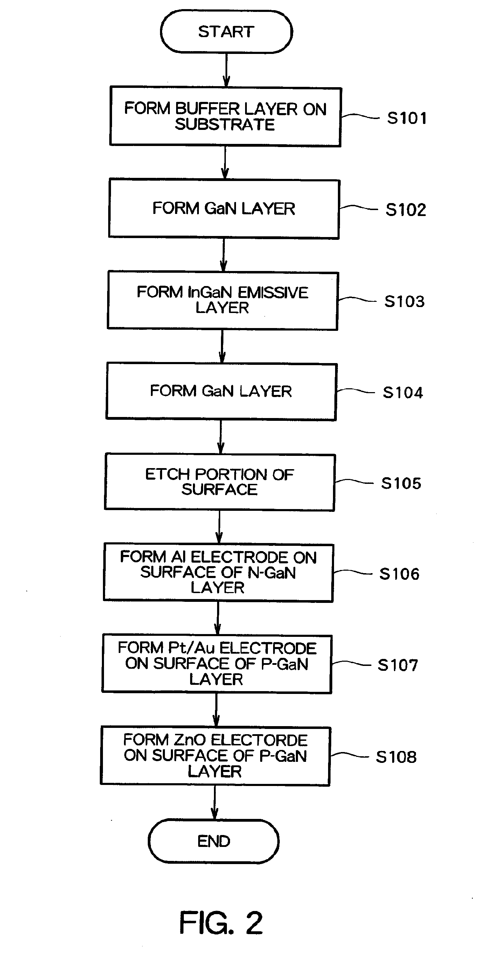

Fig. 2 shows a flowchart for the manufacturing process of the semiconductor device shown in Fig. 1. First, an n type GaN buffer layer 12 is formed on a sapphire substrate 10 through MOCVD or the like (step S101). It is preferable that the GaN buffer layer 12 be formed at relatively low temperature. It is also preferable to first form a SiN layer before forming the GaN buffer layer 12 and then form the GaN buffer layer 12 on the SiN. Next, an n type GaN layer 14 is formed on the GaN buffer layer 12 through MOCVD (step S102). It is also preferable that the n type GaN layer 14 be doped with silicon or the like during the formation process. The n type GaN buffer layer 12 may be formed to a thickness of, for example, 3 µm and the n type GaN layer 14 may be formed to a thickness of, for example, about 0.1 µm. After the n type GaN layer 14 is formed, an n type InGaN emissive layer 16 is formed to a thickness of, for example, 2 nm (step S103) using MOCVD. After the emissive layer 16 is formed, a p type GaN layer 18 is formed on the emissive layer 16 through MOCVD (step S104). The p type GaN layer may be formed to a thickness of, for example, 0.1 µm. After the p type GaN layer 18 is formed, a portion of the surface of the p type GaN layer 18 is etched to a depth of approximately 0.2 µm to expose the surface of the n type GaN buffer layer 12 (step S105). An Al electrode is formed on the exposed n type GaN buffer layer 12 as a negative electrode through evaporation, sputtering, or the like (step S106). Also, a Pt/Au electrode 22 is formed on the p type GaN layer 18 through evaporation or sputtering (step S107).

After the positive electrode 22 and the negative electrode 20 are formed, a p type ZnO transparent electrode 21 is formed on the p type GaN layer 18 abutting the positive electrode 22 through sputtering or the like (step S108). It is known that ZnO is transparent for light having a wavelength of 350 nm or greater and that a film of ZnO having a resistivity of 10⁻³ Qcm can be formed by sputtering (K. Tominaga, et al., Thin Solid Films 253 (1994) 9-13). Moreover ZnO and GaN have similar lattice constants (ZnO: a = 3.252 Å and c = 5.213 Å; GaN: a = 3.189 Å and c = 5.185 Å; and ITO: 10.13 Å) and thermal expansion coefficients (ZnO: a-axis direction 2.9 x 10⁻⁶ K⁻¹ and c-axis direction 4.75 x 10⁻⁶ K⁻¹; GaN: a-axis direction 5.59 x 10⁻⁶ K⁻¹ and c-axis direction 3.17 x 10⁻⁶ K⁻¹). Therefore, ZnO has superior contact with the p type GaN layer 18, and also, has superior etching characteristics. It is also known that a p type ZnO film can be created (Jpn. J. Appl. Phys. Vol. 38 (1999), L1205-L1207, Part 2, No. 11A. 1November, 1999). Therefore, a superior electrical contact with the p type GaN layer 18 can also be achieved.

In this manner, by forming a transparent electrode 21 by ZnO, in particular, p type ZnO, in place of a transparent electrode made of Ni/Au or ITO, it is possible to obtain uniform current by improving electrical matching with the p type GaN layer 18, to form an electrode in a desired shape, and to efficiently emit light to outside the device.

The present inventors have created light emitting elements respectively using Ni/Au, ITO, n type ZnO, and p type ZnO as the materials for the transparent electrode 21, and measured the light emission output. The results of such measurement are summarized in the following table.

**(Table 1)**

| MATERIAL FOR TRANSPARANT ELECTORODE | THICKNESS (MICROMETER) | RELATIVE OUTPUT POWER (20mA) |
|---|---|---|
| Ni/Au | 0.02/0.02 | 1 |
| ITO | 0.2 | 0.8-1.2 |
| n-ZnO | 0.2 | 1.5-1.8 |
| p-ZnO | 0.2 | 1.8-2.0 |

In this experiment, the wavelength of the emitted light was 450 nm for all sample light emitting elements. As is clear from Table 1, the n type ZnO and p type ZnO both have superior relative output powers compared to the other transparent electrode materials (Ni/Au and ITO). In particular, with the p type ZnO, a relative output power of approximately twice the conventional relative output power is obtained, and, therefore, light can be efficiently extracted to the outside with the transparent electrode made of p type ZnO.

In the present embodiment, InGaN is described as an example material for the emissive layer. However, any other suitable material can be used as long as the material is a GaN-based compound semiconductor.

Also, in the present embodiment, a structure of substrate/n-GaN layer/GaN-based emissive layer/p-GaN layer is described. However, a structure of substrate/p-GaN layer/GaN-based emissive layer/n-GaN layer can also be employed. In this case, a negative electrode is formed on the n-GaN layer and an n type ZnO transparent electrode is formed abutting the negative electrode.

As described, according to the present invention, because ZnO is used for the transparent electrode, it is possible to efficiently conduct light emitted from the emissive layer to the outside, where it can be viewed. In this manner, it is possible to improve the light emission efficiency when the present invention is applied to light emitting elements.

## Claims

1. A gallium nitride-based compound semiconductor device comprising:
a substrate;
a first conductive type GaN-based layer formed on said substrate;
a GaN-based emissive layer formed on said first conductive type GaN-based layer;
a second conductive type GaN-based layer formed on said GaN-based emissive layer;
a first electrode formed on said first conductive type GaN-based layer; and
a second electrode formed on said second conductive type GaN-based layer, wherein
a portion of said second electrode is formed by a transparent ZnO electrode.

2. A gallium nitride-based compound semiconductor device according to claim 1, wherein said transparent ZnO electrode is of the second conductive type.

3. A gallium nitride-based compound semiconductor device comprising:
a substrate;
an n type GaN-based layer formed on said substrate;
a GaN-based emissive layer formed on said n type GaN-based layer;
a p type GaN-based layer formed on said GaN-based emissive layer;
a negative electrode formed on said n type GaN-based layer;
a positive electrode formed on said p type GaN-based layer; and
a transparent ZnO electrode formed on said p type GaN-based layer and abutting said positive electrode.

4. A gallium nitride-based compound semiconductor device according to claim 3, wherein said transparent ZnO electrode is of p type.
